# EUROPÄISCHE PATENTSCHRIFT

(11) **EP 3 339 656 B1**
(45) Veröffentlichungstag und Bekanntmachung des Hinweises auf die Patenterteilung: **11.11.2020**
(21) Anmeldenummer: 16206403.4
(22) Anmeldetag: 22.12.2016
(51) Int. Cl.: F04D 29/58, F04D 29/02, F04D 13/06, H05K 7/20

(54) **PUMPENAGGREGAT**
PUMP UNIT
GROUPE POMPAGE

(43) Veröffentlichungstag der Anmeldung: 27.06.2018
(73) Patentinhaber: Grundfos Holding A/S, 8850 Bjerringbro (DK)
(72) Erfinder: Jepsen, Susanne, 8800 Viborg (DK); Ellegard, Jørgen, 8680 Ry (DK); Fly-Hansen, Jakob, 8800 Viborg (DK)
(74) Vertreter: Patentanwälte Vollmann Hemmer Lindfeld Partnerschaft mbB

(56) Entgegenhaltungen:
- EP-A1- 2 651 015
- EP-A1- 2 905 471
- JP-A- 2005 019 434
- US-B1- 6 353 258

## Beschreibung

Die Erfindung betrifft ein Pumpenaggregat mit einem Elektronikgehäuse, in welchem ein metallischer Wärmeverteiler angeordnet ist.

Moderne Pumpenaggregate, insbesondere Umwälzpumpenaggregate, wie sie in Heizungsanlagen eingesetzt werden, weisen heutzutage in der Regel eine Leistungselektronik zur Regelung des elektrischen Antriebsmotors des Pumpenaggregates auf. Die Bauteile dieser Leistungselektronik, insbesondere elektronische Schalter, erzeugen Abwärme, weshalb es bekannt ist, in oder an einem Elektronikgehäuse, in welchem diese Leistungselektronik untergebracht ist, Kühlkörper bzw. Wärmeverteiler aus Metall oder wärmeleitendem Kunststoff anzuordnen. Bei Pumpenaggregaten ist es darüber hinaus in der Regel gewünscht, dass das Elektronikgehäuse dicht ist, um ein Eindringen von Feuchtigkeit zu verhindern. Aus diesem Grunde ist es bevorzugt, auch Wärmeverteiler im Inneren anzuordnen und nicht nach außen zu führen. Dennoch sollen die Wärmeverteiler möglichst an der Außenwandung angeordnet werden, um die Wärmeabfuhr nach außen zu gewährleisten.

Im Hinblick auf diese Problematik ist es Aufgabe der Erfindung, ein Pumpenaggregat mit einem Elektronikgehäuse und einem in diesem angeordneten metallischen Wärmeverteiler dahingehend zu verbessern, dass der Wärmeverteiler sicher an einer Außenwandung des Elektronikgehäuses gehalten wird und einen guten Wärmeübergang über diese Außenwandung nach außen ermöglicht.

Eine alternative Lösung zur Kühlung elektronischer Komponenten in einem Pumpenaggregat offenbart EP 2 905 471 A1, gemäß der eine wärmeleitende Verbindung zu einem Spalttopf des Motors hergestellt wird, so dass über dieser Wärme auf das zu fördernde Medium abgeleitet werden kann. Ferner ist es bekannt, die gesamte Elektronik einschließlich wärmeleitender Elemente in ein Harz, welches gleichzeitig das Gehäuse bildet, einzugießen. Dies ist aus EP 2 651 015 A1 bekannt. Nachteilig bei einer derartigen Anordnung ist, dass die elektronischen Komponenten nach dem Eingießen nicht mehr zugänglich sind. Ferner ist es aus JP 2005019434 A bekannt, einen Wärmeverteiler an der Außenseite eines Elektronikgehäuses anzuordnen, wobei in der entsprechenden Gehäusewandung Ausnehmungen zur Aufnahme elektronischer Bauteile vorgesehen sind, so dass diese mit dem Wärmeverteiler in Kontakt treten können. Eine solche Ausgestaltung ist bei Pumpenaggregaten nachteilig, da sich Schwierigkeiten bei der Abdichtung ergeben können.

Diese Aufgabe wird durch ein Pumpenaggregat mit den in Anspruch 1 angegebenen Merkmalen gelöst. Bevorzugte Ausführungsformen ergeben sich aus den Unteransprüchen, der nachfolgenden Beschreibung sowie den beigefügten Figuren.

Das erfindungsgemäße Pumpenaggregat weist in herkömmlicher Weise eine Pumpe mit einem elektrischen Antriebsmotor auf. Bevorzugt handelt es sich bei der Pumpe um eine Kreiselpumpe, welche zumindest ein in einem Pumpengehäuse angeordnetes rotierendes Laufrad aufweist. Das Pumpenaggregat weist erfindungsgemäß ferner ein Elektronikgehäuse auf, in welchem elektronische und/oder elektrische Bauteile zur Ansteuerung bzw. Regelung des Pumpenaggregates, das heißt, dessen elektrischen Antriebsmotors angeordnet sind. Bei den elektronischen Bauteilen kann es sich insbesondere um Bauteile einer Leistungselektronik, wie eines Frequenzumrichters, handeln.

Das Elektronikgehäuse ist vorzugsweise vollständig aus Kunststoff ausgebildet, weist erfindungsgemäß jedoch zumindest eine Außenwandung mit zumindest einem Wandabschnitt aus einem ersten Kunststoffmaterial auf. Ferner ist zumindest ein metallischer Wärmeverteiler in dem Elektronikgehäuse vorhanden, welcher im Inneren des Elektronikgehäuses mit einem zu kühlenden elektronischen Bauteil in wärmeleitender Verbindung ist. Der Wärmeverteiler ist an der Innenseite des genannten Wandabschnittes aus dem ersten Kunststoffmaterial angeordnet, wobei die Innenseite dem Innenraum des Elektronikgehäuses zugewandt ist. Dadurch, dass der metallische Wärmeverteiler an der Innenseite des Wandabschnittes gelegen ist, kann die Wärme durch den Wandabschnitt nach außen abgeführt werden. Es handelt sich bei diesem Wandabschnitt um eine Außenwandung des Elektronikgehäuses, welche an ihrer Außenseite durch die Umgebungsluft gekühlt wird.

Erfindungsgemäß ist der metallische Wärmeverteiler in ein zweites, von dem ersten Kunststoffmaterial verschiedenes Kunststoffmaterial eingegossen, welches mit dem ersten Kunststoffmaterial verbunden ist. Das bedeutet, der Wärmeverteiler ist nicht vollständig in das erste Kunststoffmaterial, welches den genannten Wandabschnitt bildet, eingegossen, sondern in ein zweites, von diesem Kunststoffmaterial verschiedenes Kunststoffmaterial eingegossen, welches wiederum mit dem ersten Kunststoffmaterial verbunden ist. Durch die Verwendung zweier unterschiedlicher Kunststoffmaterialien ist es möglich, den Wärmeverteiler fest in die Kunststoffmaterialien einzubetten, ohne dass es zu derartigen thermischen Spannungen kommt, dass das Kunststoffmaterial später reißt. Durch die direkte Einbindung in das Kunststoffmaterial wird zum einen die Montage vereinfacht, zum anderen auch der Wärmeübergang nach außen durch den Wandabschnitt hinaus verbessert, da isolierende Luftschichten vermieden werden.

Vorzugsweise weist das zweite Kunststoffmaterial eine größere Elastizität auf als das erste Kunststoffmaterial. Dadurch, dass das zweite Kunststoffmaterial ein elastischeres Kunststoffmaterial ist, kann sich dasjenige Kunststoffmaterial, in welches der Wärmeverteiler eingegossen ist, in einem gewissen Maße dehnen, sodass thermische Spannungen aufgrund Größenänderungen des Wärmeverteilers vermieden werden können. Das erste Kunststoffmaterial hingegen kann ein vergleichsweise starres Kunststoffmaterial sein, welches dem Elektronikgehäuse die erforderliche Steifigkeit und Formstabilität gibt. Bei dem ersten Kunststoffmaterial handelt es sich vorzugsweise um ein relativ starres thermoplastisches Kunststoffmaterial, wie beispielsweise Polycarbonat. Dieses Material hat vorzugsweise einen Elastizitätsmodul (E-Modul) im Bereich zwischen 1.500 und 3.000 MPa. Bei dem zweiten Kunststoffmaterial handelt es sich hingegen um ein elastisches Kunststoffmaterial, insbesondere ein thermoplastisches Elastomer oder thermoplastisches Vulkanisat. Ein solches kann beispielsweise einen E-Modul im Bereich von 10 bis 100 MPa aufweisen. Das bedeutet, vorzugsweise ist der E-Modul des ersten Kunststoffmaterials mindestens 10-, vorzugsweise mindestens 20-mal größer als der des Elastizitätsmoduls des zweiten Kunststoffmaterials. Das zweite Kunststoffmaterial weist bevorzugt eine Härte im Bereich von 40 bis 95 Shore-A auf.

Besonders bevorzugt ist der Wärmeverteiler zumindest mit einem Oberflächenabschnitt in direkter Anlage mit dem ersten Kunststoffmaterial. Das heißt, eine Oberfläche des Wärmeverteilers liegt direkt an dem ersten Kunststoffmaterial an, sodass ein direkter Wärmeübergang von dem Wärmeverteiler auf das erste Kunststoffmaterial, welches, wie beschrieben, vorzugsweise die Außenwandung des Elektronikgehäuses bildet, sichergestellt wird.

Weiter bevorzugt ist der Wärmeverteiler zwischen dem ersten und dem zweiten Kunststoffmaterial eingegossen. Dazu kann der Wärmeverteiler flächig an dem ersten Kunststoffmaterial anliegen und dann an seiner dem ersten Kunststoffmaterial abgewandten Seite von dem zweiten Kunststoffmaterial umgossen sein, wobei das zweite Kunststoffmaterial im Umfang des Wärmeverteilers mit dem ersten Kunststoffmaterial so in Kontakt kommt, dass auch eine feste Verbindung zwischen den beiden Kunststoffmaterialien gegeben ist. So wird der Wärmeverteiler dann zwischen dem ersten und dem zweiten Kunststoffmaterial fixiert. Diese Fertigung kann besonders bevorzugt im Zweikomponenten-Spritzguss durchgeführt werden, in welchem der Wärmeverteiler in das Spritzgusswerkzeug eingelegt wird. Dies kann nach dem Gießen des Wandabschnittes aus dem ersten Kunststoffmaterial, aber auch schon vor dem Gießen dieses Wandabschnittes aus dem ersten Kunststoffmaterial erfolgen. Durch das direkte Eingießen des Wärmeverteilers in die zwei Kunststoffmaterialien werden spätere Montageschritte vermieden. Ferner wird eine feste spielfreie Verbindung zwischen Wärmeverteiler und dem Wandabschnitt aus dem ersten Kunststoffmaterial mit einem guten Wärmeübergang geschaffen.

Weiter bevorzugt ist der Wärmeverteiler plattenförmig, wobei eine erste Oberfläche des Wärmeverteilers mit dem ersten Kunststoffmaterial und eine abgewandte zweite Oberfläche des Wärmeverteilers mit dem zweiten Kunststoffmaterial in Kontakt ist. Die zwischen den Oberflächen gelegene Umfangskante ist vorzugsweise von dem zweiten Kunststoffmaterial umschlossen, kann aber auch zumindest abschnittweise von dem ersten Kunststoffmaterial umgeben sein. Besonders bevorzugt ist der Wärmeverteiler ein Blechbauteil. Das heißt, der Wärmeverteiler ist vorzugsweise aus einem Blech geschnitten bzw. gestanzt und gegebenenfalls noch umformend in eine gewünschte Form gebracht. Dies ermöglicht eine kostengünstige Fertigung und gleichzeitig eine große wärmeabgebende Oberfläche. Dabei liegt die wärmeabgebende Oberfläche vorzugsweise an dem Wandabschnitt aus dem ersten Kunststoffmaterial an, sodass die Wärme auf das erste Kunststoffmaterial und über dieses nach außen abgegeben wird.

Gemäß einer weiteren bevorzugten Ausführungsform der Erfindung weist der Wärmeverteiler an einer dem Innenraum des Elektronikgehäuses zugewandten Oberfläche zumindest einen freiliegenden Abschnitt auf, welcher nicht von Kunststoffmaterial überdeckt ist und mit welchem zumindest ein in dem Innenraum angeordnetes elektronisches Bauteil in wärmeleitender Verbindung ist. Der freiliegende Abschnitt kann dadurch geschaffen sein, dass das zweite Kunststoffmaterial eine Aussparung aufweist, in welcher der Wärmeverteiler nicht überdeckt ist. Dabei ist der freiliegende Abschnitt allerdings vorzugsweise kleiner als die gesamte, dem Innenraum des Elektronikgehäuses zugewandte Oberfläche des Wärmeverteilers, sodass der Wärmeverteiler in den übrigen Bereichen von dem zweiten Kunststoffmaterial überdeckt wird. Dies dient zum einen der sicheren Fixierung des Wärmeverteilers, zum anderen aber auch der elektrischen Isolation, da durch das zweite Kunststoffmaterial verhindert wird, dass elektrisch leitende Bauteile im Inneren des Elektronikgehäuses mit dem Wärmeverteiler in Kontakt kommen. Bei dem elektronischen Bauteil handelt es sich, wie oben beschrieben, vorzugsweise um ein Bauteil einer Leistungselektronik, insbesondere um einen Leistungsschalter eines Frequenzumrichters.

Das elektronische Bauteil kann in direktem Kontakt mit dem freiliegenden Abschnitt des Wärmeverteilers sein. Alternativ können zwischen dem elektronischen Bauteil und dem Wärmeverteiler weitere wärmeleitende Elemente, vorzugsweise ein Wärmeleitkissen oder ein wärmeleitendes Medium, angeordnet sein. Besonders bevorzugt handelt es sich dabei um verformbare Medien oder Elemente, welche durch ihre Verformung Toleranzen ausgleichen können und dennoch einen wärmeleitenden Kontakt zwischen dem elektronischen Bauteil und dem Wärmeverteiler sicherstellen können.

Gemäß einer weiteren bevorzugten Ausführungsform der Erfindung ist in dem Innenraum des Elektronikgehäuses eine Leiterplatte mit elektronischen Bauteilen angeordnet, welche sich weiter bevorzugt parallel zu dem Wandabschnitt und/oder dem Wärmeverteiler erstreckt. Auf dieser Leiterplatte ist weiter bevorzugt auch das zumindest eine elektronische Bauteil angeordnet, welches in wärmeleitendem Kontakt mit dem Wärmeverteiler steht. Durch eine parallele Anordnung von Leiterplatte und Wärmeverteiler kann ein kompakter Aufbau erreicht werden, da so die Leiterplatte, der Wärmeverteiler und weiter bevorzugt der Wandabschnitt geschichtet übereinander angeordnet werden können.

Gemäß einer speziellen Ausführungsform der Erfindung kann der Wärmeverteiler zumindest eine Ausnehmung aufweisen, durch welche sich zumindest ein aus dem ersten Kunststoffmaterial geformtes Element von einer Außenseite des Wärmeverteilers her in den Innenraum des Elektronikgehäuses hinein erstreckt. Das heißt, das aus dem ersten Kunststoffmaterial geformte Element erstreckt sich durch die Ausnehmung in dem Wärmeverteiler hindurch. Dieses Element kann beispielsweise Teil eines Tasters oder Schalters sein oder auch Teil eines Anzeigeelementes oder Steckkontaktes sein. Dabei sind die Elemente bevorzugt einstückig aus dem ersten Kunststoffmaterial gemeinsam mit dem beschriebenen Wandabschnitt ausgebildet, was eine kostengünstige Fertigung in einem Schritt im Spritzguss ermöglicht. Die Ausnehmung in dem Wärmeverteiler erlaubt es, an dem Wandabschnitt, an dem der Wärmeverteiler gelegen ist, dennoch weitere Elemente, wie Bedienelemente, Anzeigeelemente oder Anschlusselemente, auszubilden und anzuordnen. Durch die Ausnehmung hindurch können diese Elemente mit elektrischen und/oder elektronischen Bauelementen im Inneren des Elektronikgehäuses, insbesondere auf der beschriebenen Leiterplatte, in Kontakt treten bzw. zusammenwirken.

Gemäß einer besonders bevorzugten Ausführungsform der Erfindung ist der beschriebene Wandabschnitt aus dem ersten Kunststoffmaterial, an welchem der Wärmeverteiler gelegen ist, ein Deckel des Elektronikgehäuses. Dies ermöglicht eine einfache Montage auch des Wärmeverteilers, da dieser gemeinsam mit dem Deckel, in welchen er eingegossen ist, auf ein Unterteil des Elektronikgehäuses aufgesetzt werden kann und dabei mit zumindest einem elektronischen Bauteil im Inneren des Elektronikgehäuses in wärmeleitenden Kontakt tritt. Dazu kann die Anordnung eines verformbaren wärmeleitenden Elementes oder Mediums auf dem elektronischen Bauteil von Vorteil sein, so dass der Wärmeverteiler dann mit dem Deckel auf dieses verformbare wärmeleitende Element aufgepresst wird. So wird unter Verformung des Elementes oder Mediums eine wärmeleitende Verbindung zwischen dem elektronischen Bauteil und dem Wärmeverteiler bzw. einem freiliegenden Abschnitt des Wärmeverteilers geschaffen. Der Deckel kann gleichzeitig das Elektronikgehäuses verschließen und abdichten. Dabei ist es gemäß einer besonderen Ausführungsform der Erfindung möglich, dass aus dem zweiten Kunststoffmaterial, in welches der Wärmeverteiler eingegossen ist, an dem Deckel ebenfalls eine Dichtung ausgebildet ist.

Vorzugsweise sind sowohl der Deckel des Elektronikgehäuses als auch der übrige Teil des Elektronikgehäuses, welcher durch den Deckel verschlossen wird, aus Kunststoff ausgebildet. Dabei ist es weiter bevorzugt, dass der Deckel mit dem übrigen Teil des Elektronikgehäuses, d. h., dem Gehäuseunterteil dicht verschweißt wird. Dies kann beispielsweise durch Laser- oder Ultraschallschweißen geschehen, wenn beide Teile aus geeigneten Kunststoffen, insbesondere thermoplastischen Kunststoffen, ausgebildet sind. Besonders bevorzugt ist dabei zum Laserschweißen eines der Bauteile für die Strahlung des Lasers durchgängig und das andere zu verschweißende Bauteil für die Strahlung des Lasers undurchgängig bzw. undurchlässig. Dann kann der Laser durch das für die Strahlung durchlässige Bauteil hindurch auf das andere Bauteil gerichtet werden, sodass beide Bauteile an ihrer Anlagefläche miteinander verschweißt werden können. In diesem Fall ist vorzugsweise der Deckel aus einem für die Laserstrahlung durchlässigen Material gefertigt. Dabei kann für den Deckel dennoch ein entsprechend steifes und festes Kunststoffmaterial zur Verwendung kommen, wie es oben beschrieben wurde. Auch wäre es möglich, das zweite Kunststoffmaterial, in welches der Wärmeverteiler eingesetzt ist, zu nutzen, um zwei Gehäuseteile des Elektronikgehäuses, insbesondere einen Deckel mit einem Unterteil zu verschweißen. So könnte dieses zweite Kunststoffmaterial aufgeschmolzen werden, um im Bereich einer Schnittstelle bzw. Trennfuge eine dichte Verbindung zwischen den Gehäuseteilen herzustellen. Dazu erstreckt sich dann das zweite Kunststoffmaterial ebenfalls über die Schnittstelle, an welcher der Wandabschnitt, mit welchem das zweite Kunststoffmaterial verbunden ist, mit einem weiteren Gehäuseteil, beispielsweise einem Gehäuseunterteil, verbunden wird. Das zweite Kunststoffmaterial kann dabei gleichzeitig, wie oben beschrieben, eine Dichtung ausbilden.

An dem Wandabschnitt aus dem ersten Kunststoffmaterial kann weiter bevorzugt an einer der Innenseite abgewandten Außenseite eine Abdeckfolie bzw. Deckfolie angebracht sein. Eine solche Abdeckfolie kann beispielsweise der Beschriftung oder farblichen Gestaltung der Außenseite des Wandabschnittes dienen. Insbesondere jedoch kann die Abdeckfolie auch zumindest ein in dem Wandabschnitt vorhandenes Loch überdecken. Ein solches Loch kann beispielsweise ein Loch sein, unter welchem im Inneren des Elektronikgehäuses ein Anzeigeelement, wie beispielsweise eine Leuchtdiode, angeordnet ist. Deren Licht kann dann durch die Abdeckfolie hindurch von außen betrachtet werden. Ferner kann die Abdeckfolie auch elastisch ausgebildet sein und so Bedienelemente wie Taster überdecken, welche durch die Abdeckfolie hindurch gedrückt werden können. Die Abdeckfolie dient dabei zum einen der optischen Gestaltung der Außenseite, zum anderen dann aber auch der Abdichtung eventuell erforderlicher bzw. vorhandener Öffnungen. Die Abdeckfolie ist vorzugsweise ebenfalls aus Kunststoff und weiter bevorzugt mit dem ersten Kunststoffmaterial an der Außenseite verklebt.

Besonders bevorzugt handelt es sich bei dem erfindungsgemäßen Pumpenaggregat um ein Umwälzpumpenaggregat und weiter bevorzugt um ein Heizungs- und/oder Klimaanlagenumwälzpumpenaggregat. Dabei weist das Pumpenaggregat vorzugsweise einen nasslaufenden elektrischen Antriebsmotor auf.

Nachfolgend wird die Erfindung beispielhaft anhand der beigefügten Figuren beschrieben. In diesen zeigt:
- Fig. 1: eine Explosionsansicht eines erfindungsgemäßen Pumpenaggregates,

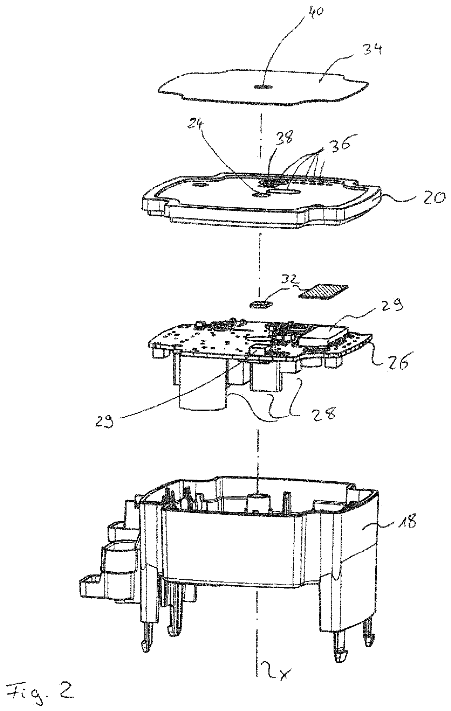

- Fig. 2: eine Explosionsansicht des Elektronikgehäuses des Pumpenaggregates gemäß Fig. 1,
- Fig. 3: eine Schnittansicht des Elektronikgehäuses gemäß Fig. 2,
- Fig. 4: eine Schnittansicht des Deckels des Elektronikgehäuses gemäß Fig. 3,
- Fig. 5 und 6: jeweils eine Detail-Schnittansicht des Elektronikgehäuses gemäß Fig. 3, welche den Kontakt jeweils eines elektrischen Bauteils mit einem Wärmeverteiler zeigen.

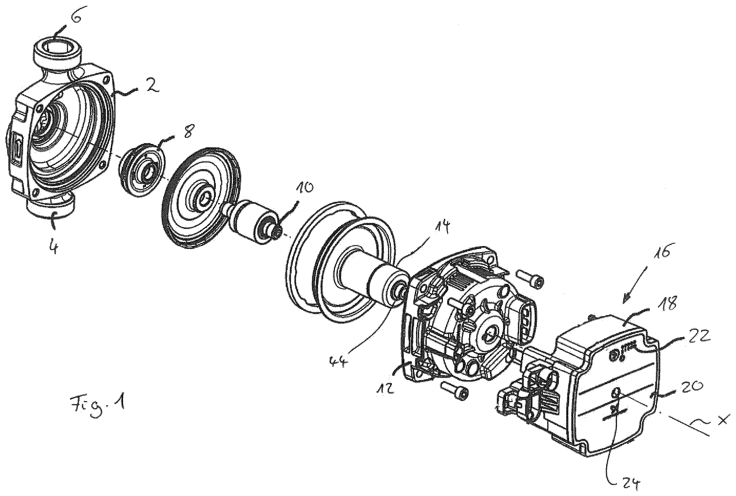

Bei dem beispielhaft beschriebenen Pumpenaggregat handelt es sich um ein Heizungsumwälzpumpenaggregat. Dieses weist, wie in Fig. 1 gezeigt, in bekannter Weise ein Pumpengehäuse 2 mit einem Einlassstutzen 4 und einem Auslassstutzen 6 auf. Im Inneren des Pumpengehäuses 2 ist ein Laufrad 8 angeordnet, welches von einem Rotor 10 eines mit dem Pumpengehäuse 2 verbundenen elektrischen Antriebsmotors drehend angetrieben wird. Der hier nicht gezeigte Stator des elektrischen Antriebsmotors ist im Inneren des Stator- bzw. Motorgehäuses 12 angeordnet. Der Rotor 10 dreht sich im Inneren des in dem Statorgehäuse 12 angeordneten Stators. Der hier gezeigte elektrische Antriebsmotor ist als nasslaufender Motor ausgebildet. Das heißt, der Rotor 10 ist von dem Stator durch ein Spaltrohr bzw. einen Spalttopf 14 getrennt. An dem in Richtung der Längs- bzw. Drehachse X dem Pumpengehäuse 2 abgewandten Axialende des Statorgehäuses 12 ist ein Klemmenkasten bzw. Elektronikgehäuse 16 angeordnet, welches die elektronischen Bauteile zur Steuerung des elektrischen Antriebsmotors beherbergt. Das Elektronikgehäuse 16 ist aus Kunststoff gebildet und weist ein Unterteil 18 auf, welches eine topfförmige Gestalt hat und durch einen Deckel 20 axialseitig verschlossen ist. In dem Deckel 20 sind Bedien- und Anzeigeelemente 22 sowie eine zentrale Öffnung 24 gelegen.

Im Inneren des Elektronikgehäuses ist eine Leiterplatte 26 angeordnet, welche elektronische Bauelemente 28 und 29 trägt, welche eine Steuerungs- bzw. Regelungselektronik für den elektrischen Antriebsmotor bilden. Bei den elektronischen Bauelementen 29 handelt es sich um zu kühlende elektronische Bauelemente, nämlich die Leistungsschalter eines Frequenzumrichters. Die elektronischen Bauelemente 29 sind an der dem Deckel 20 zugewandten Seite der Leiterplatte 26 angeordnet. Die Leiterplatte 26 erstreckt sich normal zu der Längsachse X und parallel zu dem Deckel 20. Der Deckel 20 ist wie das Unterteil 18 aus Kunststoff gefertigt, nämlich aus einem ersten Kunststoffmaterial. Der Deckel 20 bildet dabei einen Wandabschnitt 21, an dessen Innenseite ein Wärmeverteiler 30 gelegen ist. Der Wärmeverteiler 30 ist über die Wärmeleitkissen 32 mit den elektronischen Bauelementen 29 in wärmeleitender Verbindung. An seiner Außenseite, das heißt, der in Richtung der Längsachse X dem Unterteil 18 abgewandten Seite, ist der Wandabschnitt 21 des Deckels 20 von einer Abdeckfolie 34 aus Kunststoff überdeckt. Die Abdeckfolie 34 verschließt dabei Öffnungen 36 in dem Deckel 20 bzw. dem von diesem gebildeten Wandabschnitt 21. Die Öffnungen 36 dienen dazu, dass durch sie auf der Leiterplatte 26 angeordnete Leuchtdioden hindurchleuchten können. In einer der Öffnungen 36 ist darüber hinaus eine federnde Zunge 38 einstückig aus dem ersten Kunststoffmaterial des Deckels 20 ausgebildet. Die federnde Zunge 38 bildet Teil eines Tasters bzw. eines Schalters. Sie kann durch die Abdeckfolie 34 hindurch gegen einen auf der Leiterplatte 26 angeordneten Taster gedrückt werden. Der Öffnung 24 gegenüberliegend ist in der Abdeckfolie 34 eine Öffnung 40 gelegen, sodass die Öffnung 24 in dem Deckel nicht verschlossen wird. Die Öffnung 24 in dem Deckel 20 liegt einem rohrförmigen Durchgang 42 in dem Unterteil 18 des Elektronikgehäuses gegenüber. Durch die Öffnung 24 und den rohrförmigen Durchgang 42 hindurch ist es möglich, ein Werkzeug durch das Elektronikgehäuse 16 hindurchzuführen, um in ein Betätigungselement 44 an der Stirnseite des Spaltrohres 14 einzugreifen. Das Betätigungselement 44 kann eine Schraube oder vorzugsweise ein Element sein, über welches der Rotor 10 im Inneren des Spaltrohres 14 drehbar ist.

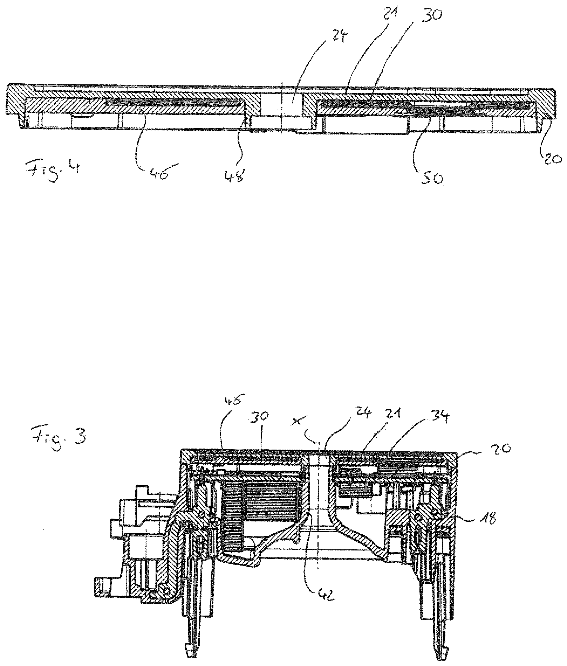

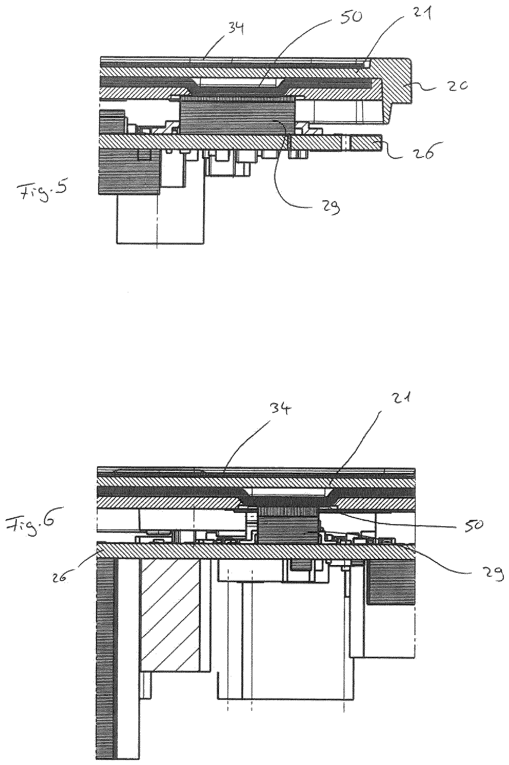

Wie in den Schnittansichten in Fig. 3 bis 6 zu erkennen ist, liegt der Wärmeverteiler 30 flächig an dem Wandabschnitt 21 des Deckels 20 an. Der Wandabschnitt 21 ist wie der gesamte Deckel 20 aus einem ersten, vergleichsweise starren Kunststoffmaterial ausgebildet. An der dem Wandabschnitt 21 abgewandten Oberfläche des Wärmeverteilers 30 ist dieser von einem zweiten Kunststoffmaterial 46 überdeckt. Das zweite Kunststoffmaterial 46 ist elastischer als das erste Kunststoffmaterial, aus welchem der Wandabschnitt 21 geformt ist. Der Wärmeverteiler 30 ist zwischen dem Wandabschnitt 21 und dem zweiten Kunststoffmaterial 46 eingegossen, wobei das zweite Kunststoffmaterial 46 im Umfangsbereich des Wärmeverteilers 30 in direkter stoffschlüssiger Verbindung mit dem Wandabschnitt 21 bzw. weiteren Teilen des Deckels 20 ist. So wird der Wärmeverteiler 30 in dem Deckel 20 spielfrei fixiert und in fester Anlage an dem Wandabschnitt 21 gehalten, sodass ein günstiger Wärmeübergang von dem Wärmeverteiler 30 auf den Wandabschnitt 21 gegeben ist. Die Elastizität des zweiten Kunststoffmaterials 46 ermöglicht es dabei, Wärmedehnungen des Wärmeverteilers 30, welcher aus einem Metallblech gefertigt ist, zu kompensieren.

Der Wärmeverteiler 30 weist Öffnungen auf, durch welche sich Abschnitte des Wandabschnittes 21 bzw. einstückig mit diesem geformte Elemente durch den Wärmeverteiler 30 in das Innere hinein erstrecken können. So ist zum Beispiel in Fig. 4 ein die zentrale Öffnung 34 umgebender rohrförmiger Stutzen 48 gezeigt, welcher beim Aufsetzen des Deckels dicht mit dem rohrförmigen Durchgang 42 in Verbindung tritt.

Der Wärmeverteiler 30 weist an denjenigen Abschnitten, welche mit den elektronischen Bauteilen 29 in wärmeleitende Verbindung treten sollen, freiliegende Abschnitte 50 auf, welche nicht von dem zweiten Kunststoffmaterial 46 überdeckt sind. Im gezeigten Beispiel kragen die freiliegenden Abschnitte 50 auch zusätzlich noch nach innen, das heißt, von dem Wandabschnitt 21 weg, aus. An den freiliegenden Abschnitten 50 liegen die Wärmeleitkissen 32 an, sodass in diesem Bereich eine wärmeleitende Verbindung zwischen den elektronischen Bauteilen 29 und dem Wärmeverteiler 30 geschaffen wird. Die verformbaren Wärmeleitkissen 32 ermöglichen es dabei, den Deckel 20 fest auf das Unterteil 18 aufzusetzen, wobei gleichzeitig der Wärmeverteiler 30 an die Wärmeleitkissen 32 gepresst wird, welche zuvor auf die elektronischen Bauteile 29 aufgesetzt worden sind.

### Bezugszeichenliste

- 2 -: Pumpengehäuse
- 4 -: Einlassstutzen
- 6 -: Auslassstutzen
- 8 -: Laufrad
- 10 -: Rotor
- 12 -: Statorgehäuse
- 14 -: Spaltrohr
- 16 -: Elektronikgehäuse
- 18 -: Unterteil
- 20 -: Deckel
- 21 -: Wandabschnitt
- 22 -: Bedien- und Anzeigeelemente
- 24 -: Öffnung
- 26 -: Leiterplatte
- 28, 29 -: elektronische Bauelemente
- 30 -: Wärmeverteiler
- 32 -: Wärmeleitkissen
- 34 -: Abdeckfolie
- 36 -: Öffnungen
- 38 -: federnde Zunge
- 40 -: Öffnungen
- 42 -: rohrförmiger Durchgang
- 44 -: Betätigungselement
- 46 -: zweites Kunststoffmaterial
- 48 -: Stutzen
- 50 -: freiliegende Abschnitte
- X -: Längsachse

## Patentansprüche

1. Pumpenaggregat mit einem Elektronikgehäuse (16), welches eine Außenwandung mit zumindest einem Wandabschnitt (21) aus einem ersten Kunststoffmaterial aufweist, an dessen dem Innenraum des Elektronikgehäuses (16) zugewandter Innenseite ein metallischer Wärmeverteiler (30) angeordnet ist, welcher im Inneren des Elektronikgehäuses (16) mit einem zu kühlenden elektronischen Bauteil (29) in wärmeleitender Verbindung ist, so dass die Wärme durch den Wandabschnitt (21) nach außen abgeführt wird, wobei der metallische Wärmeverteiler (30) nicht vollständig in das erste Kunststoffmaterial, sondern in ein zweites, von dem ersten Kunststoffmaterial verschiedenes Kunststoffmaterial (46) eingegossen ist, welches mit dem ersten Kunststoffmaterial verbunden ist.

2. Pumpenaggregat nach Anspruch 1, **dadurch gekennzeichnet, dass** das zweite Kunststoffmaterial (46) eine größere Elastizität aufweist als das erste Kunststoffmaterial.

3. Pumpenaggregat nach Anspruch 1 oder 2, **dadurch gekennzeichnet, dass** der Wärmeverteiler (30) zumindest mit einem Oberflächenabschnitt in direkter Anlage mit dem ersten Kunststoffmaterial ist.

4. Pumpenaggregat nach einem der vorangehenden Ansprüche, **dadurch gekennzeichnet, dass** der Wärmeverteiler (30) zwischen dem ersten und dem zweiten Kunststoffmaterial (46) eingegossen ist.

5. Pumpenaggregat nach einem der vorangehenden Ansprüche, **dadurch gekennzeichnet, dass** der Wärmeverteiler (30) plattenförmig ist, wobei eine erste Oberfläche des Wärmeverteilers (30) mit dem ersten Kunststoffmaterial und eine abgewandte zweite Oberfläche des Wärmeverteilers (30) mit dem zweiten Kunststoffmaterial (46) in Kontakt ist.

6. Pumpenaggregat nach einem der vorangehenden Ansprüche, **dadurch gekennzeichnet, dass** der Wärmeverteiler (30) ein Blechbauteil ist.

7. Pumpenaggregat nach einem der vorangehenden Ansprüche, **dadurch gekennzeichnet, dass** der Wärmeverteiler (30) an einer dem Innenraum des Elektronikgehäuses (16) zugewandten Oberfläche zumindest einen freiliegenden Abschnitt (50) aufweist, welcher nicht von Kunststoffmaterial (46) überdeckt ist und mit welchem zumindest ein in dem Innenraum angeordnetes elektronisches Bauteil (29) in wärmeleitender Verbindung ist.

8. Pumpenaggregat nach Anspruch 7, **dadurch gekennzeichnet, dass** zwischen dem elektronischen Bauteil (29) und dem Wärmeverteiler (30) ein Wärmeleitkissen (32) oder wärmeleitendes Medium angeordnet ist.

9. Pumpenaggregat nach einem der vorangehenden Ansprüche, **dadurch gekennzeichnet, dass** in dem Innenraum des Elektronikgehäuses (16) eine Leiterplatte (26) mit elektronischen Bauteilen (28, 29) angeordnet ist, welche sich vorzugsweise parallel zu dem Wandabschnitt (21) und/oder dem Wärmeverteiler (30) erstreckt.

10. Pumpenaggregat nach einem der vorangehenden Ansprüche, **dadurch gekennzeichnet, dass** der Wärmeverteiler (30) zumindest eine Ausnehmung aufweist, durch welche sich ein aus dem ersten Kunststoffmaterial geformtes Element (48) von einer Außenseite des Wärmeverteilers (30) her in den Innenraum des Elektronikgehäuses (16) hinein erstreckt.

11. Pumpenaggregat nach einem der vorangehenden Ansprüche, **dadurch gekennzeichnet, dass** der Wandabschnitt (21) aus dem ersten Kunststoffmaterial ein Deckel (20) des Elektronikgehäuses (16) ist.

12. Pumpenaggregat nach einem der vorangehenden Ansprüche, **dadurch gekennzeichnet, dass** an dem Wandabschnitt (21) aus dem ersten Kunststoffmaterial an einer der Innenseite abgewandten Außenseite eine Abdeckfolie (34) angebracht ist, welche insbesondere zumindest ein in dem Wandabschnitt (21) vorhandenes Loch (36) überdeckt.

13. Pumpenaggregat nach einem der vorangehenden Ansprüche, **dadurch gekennzeichnet, dass** es als Umwälzpumpenaggregat, insbesondere mit einem nasslaufenden elektrischen Antriebsmotor ausgebildet ist.

## Claims

1. A pump assembly with an electronics casing (16) comprising an outer wall with at least one wall section (21) which is of a first plastic material and on whose inner side facing the interior of the electronics casing (16) a metallic heat distributor (30) is arranged, and this heat distributor (30) in the inside of the electronics casing 816) is thermally conductively connected to an electronic component (28) to be cooled, so that the heat can be dissipated to the outside through the wall section (21)
wherein
the metallic heat distributor (30) is not completely moulded into the first plastic material, but is moulded into a second plastic material (46) which is different to the first plastic material and which is connected to the first plastic material.

2. A pump assembly according to claim 1, **characterised in that** the second plastic material (46) has a greater elasticity than the first plastic material.

3. A pump assembly according to claim 1 or 2, **characterised in that** the heat distributor (30) at least with a surface section is in direct contact with the first plastic material.

4. A pump assembly according to one of the preceding claims, **characterised in that** the heat distributor (30) is moulded between the first and the second plastic material (46).

5. A pump assembly according to one of the preceding claims, **characterised in that** the heat distributor (30) is plate-like, wherein a first surface of the heat distributor (30) is in contact with the first plastic material, and a remote, second surface of the heat distributor (30) is in contact with the second plastic material (46).

6. A pump assembly according to one of the preceding claims, **characterised in that** the heat distributor (30) is a sheet metal component.

7. A pump assembly according to one of the preceding claims, **characterised in that** the heat distributor (30) at a surface facing the interior of the electronics casing (16) comprises at least one exposed section (50) which is not covered by plastic material (46) and to which at least one electronic component (29) arranged in the interior is thermally conductively connected.

8. A pump assembly according to claim 7, **characterised in that** a thermally conductive pad (32) or a thermally conductive medium is arranged between the electronic component (29) and the heat distributor (30).

9. A pump assembly according to one of the preceding claims, **characterised in that** a circuit board (26) with electronic components (28, 29) and which preferably extends parallel to the wall section (21) and/or heat distributor (30) is arranged in the interior of the electronics casing (16).

10. A pump assembly according to one of the preceding claims, **characterised in that** the heat distributor (30) comprises at least one opening, through which an element (48) shaped from the first plastic material extends from an outer side of the heat distributor (30) into the interior of the electronics casing (16).

11. A pump assembly according to one of the preceding claims, **characterised in** the wall section (21) of the first plastic material is a cover (20) of the electronics casing (16).

12. A pump assembly according to one of the preceding claims, **characterised in that** a cover foil (34) which in particular covers at least one hole (36) present in the wall section (21) is attached on the wall section (21) of the first plastic material, at an outer side which is away from the inner side.

13. A pump assembly according to one of the preceding claims, **characterised in that** it is designed as a circulation pump assembly, in particular with a wet-running electrical drive motor.

## Revendications

1. Groupe motopompe comportant un boîtier électronique (16) qui présente une paroi extérieure ayant au moins une section de paroi (21) en une première matière plastique, un dissipateur de chaleur métallique (30) étant agencé au niveau du côté intérieur tourné vers l'espace intérieur du boîtier électronique (16), le dissipateur, à l'intérieur du boîtier électronique (16), étant relié de manière thermoconductrice à un composant électronique (29) à refroidir, de sorte que la chaleur est évacuée vers l'extérieur à travers la section de paroi (21),
dans lequel
le dissipateur de chaleur métallique (30) n'est pas entièrement coulé dans la première matière plastique, mais dans une seconde matière plastique (46) qui est différente de la première matière plastique et qui est reliée à la première matière plastique.

2. Groupe motopompe selon la revendication 1, **caractérisé en ce que** la seconde matière plastique (46) possède une élasticité plus importante que la première matière plastique.

3. Groupe motopompe selon la revendication 1 ou 2, **caractérisé en ce que** le dissipateur de chaleur (30) est en appui direct avec la première matière plastique par au moins une section de surface.

4. Groupe motopompe selon l'une des revendications précédentes, **caractérisé en ce que** le dissipateur de chaleur (30) est coulé entre la première et la seconde matière plastique (46).

5. Groupe motopompe selon l'une des revendications précédentes, **caractérisé en ce que** le dissipateur de chaleur (30) est en forme de plaque, où une première surface du dissipateur de chaleur (30) est en contact avec la première matière plastique et une seconde surface opposée du dissipateur de chaleur (30) est en contact avec la seconde matière plastique (46).

6. Groupe motopompe selon l'une des revendications précédentes, **caractérisé en ce que** le dissipateur de chaleur (30) est un composant en tôle.

7. Groupe motopompe selon l'une des revendications précédentes, **caractérisé en ce que** le dissipateur de chaleur (30) présente, au niveau d'une surface tournée vers l'intérieur du boîtier électronique (16), au moins une section exposée (50) qui n'est pas recouverte de matière plastique (46), et avec laquelle au moins un composant électronique (29) agencé dans l'espace intérieur est relié de manière thermoconductrice.

8. Groupe motopompe selon la revendication 7, **caractérisé en ce qu'**un tampon conducteur de chaleur (32) ou un milieu conducteur de chaleur est disposé entre le composant électronique (29) et le dissipateur de chaleur (30).

9. Groupe motopompe selon l'une des revendications précédentes, **caractérisé en ce qu'**une carte de circuit imprimé (26) comportant des composants électroniques (28, 29) est agencée dans l'espace intérieur du boîtier électronique (16), laquelle s'étend de préférence parallèlement à la section de paroi (21) et/ou au dissipateur de chaleur (30).

10. Groupe motopompe selon l'une des revendications précédentes, **caractérisé en ce que** le dissipateur de chaleur (30) présente au moins un évidement par lequel un élément (48) formé à partir de la première matière plastique s'étend depuis un côté extérieur du dissipateur de chaleur (30) jusqu'à l'espace intérieur du boîtier électronique (16).

11. Groupe motopompe selon l'une des revendications précédentes, **caractérisé en ce que** la section de paroi (21) constituée de la première matière plastique est un couvercle (20) du boîtier électronique (16).

12. Groupe motopompe selon l'une des revendications précédentes, **caractérisé en ce qu'**est appliqué sur la section de paroi (21) en la première matière plastique un film de recouvrement (34), sur un côté extérieur opposé au côté intérieur, qui recouvre en particulier au moins un trou (36) présent dans la section de paroi (21).

13. Groupe motopompe selon l'une des revendications précédentes, **caractérisé en ce qu'**il est réalisé sous la forme d'un groupe motopompe de circulation, en particulier avec un moteur d'entraînement électrique immergé.
